# FASCICULE DE BREVET EUROPEEN

(11) **EP 1 860 722 B1**
(45) Date de publication et mention de la délivrance du brevet: **07.04.2010**
(21) Numéro de dépôt: 07108582.3
(22) Date de dépôt: 22.05.2007
(51) Int. Cl.: H01M 10/04, H01M 10/36, H01G 9/02

(54) **Micro-composant integre associant les fonctions de recuperation et de stockage de l'energie**
Integriertes Mikrobauteil, das die Funktionen der Rückgewinnung und Speicherung von Energie verbindet
Integrated micro-component combining functions of energy recovery and storage

(30) Priorité: 24.05.2006 FR 0604707
(43) Date de publication de la demande: 28.11.2007
(73) Titulaire: Commissariat à l'Energie Atomique, 75015 Paris (FR)
(72) Inventeur: Salot, Raphaël, 38250 Lans-en-Vercors (FR); Gaillard, Frédéric, 38500 Voiron (FR); Laurent, Jean-Yves, 38420 Domene (FR); Plissonnier, Marc, 38320 Eybens (FR)
(74) Mandataire: Poulin, Gérard

(56) Documents cités:
- WO-A2-00/45457
- FR-A1- 2 831 331
- FR-A1- 2 874 128
- US-A1- 2002 004 167
- US-A1- 2003 152 815
- US-A1- 2007 212 603

## Description

### DOMAINE TECHNIQUE

L'invention concerne le domaine de la fabrication d'un composant assurant les fonctions de stockage électrochimique de l'énergie dans un volume réduit (microscopique) et permettant une intégration optimisée avec une source de récupération d'énergie et un système de gestion de l'énergie (ASIC) par exemple. L'ensemble du système est alors parfaitement adapté à l'alimentation de MEMS (pour « Microelectromechanical Systems »).

Le principal domaine d'application visé concerne « l'intelligence ambiante », c'est-à-dire des micro-capteurs (abandonnés, connectés éventuellement en réseau) parfois désignés sous les termes de « smart dust », « e-grains », etc... Ce type de produit requiert plusieurs fonctions associées dans un volume très réduit (typiquement une surface de quelques mm² à 1 cm² avec une épaisseur inférieure à 1 mm) : communication, capteur, énergie, intelligence embarquée. L'invention concerne la partie énergie de ces systèmes, éventuellement associée à l'intelligence.

### ÉTAT DE LA TECHNIQUE ANTÉRIEURE

Les systèmes électrochimiques de stockage de l'énergie peuvent être classés en deux catégories : les supercapacités et les batteries.

Les supercapacités présentent la possibilité de délivrer de fortes puissances mais au détriment de la quantité d'énergie stockée par rapport à une batterie. Les systèmes actuels de supercapacités les plus performants présentent une capacitance d'environ 7 mF (soit de l'ordre de 10 µAh pour les tensions considérées). Le problème majeur réside dans la difficulté d'intégration et de réduction de la taille à une échelle micrométrique.

Les batteries, dont la taille peut être réduite à des fins d'intégration, sont essentiellement de deux types : batteries tout solide (dénommées ci-après microbatteries) fabriquées par des techniques de dépôt sous vide, dont l'épaisseur est de quelques micromètres, et batteries obtenues par enduction avec une épaisseur de l'ordre de quelques centaines de micromètres (dénommées ci-après minibatteries). Néanmoins, une autre solution basée sur un électrolyte liquide tout en étant intégrable a également été proposée (voir la demande de brevet US 2005/0110457).

Les microbatteries « tout solide » sous forme de films minces font l'objet de nombreuses publications et brevets (voir la demande de brevet FR-A-2874128). Le principe de fonctionnement repose sur l'insertion et la désinsertion (ou intercalation - désintercalation) d'un ion de métal alcalin ou d'un proton dans l'électrode positive. Le système présenté utilise comme espèce ionique Li⁺ issu par exemple d'une électrode en lithium métallique. Toutes les couches composant la microbatterie (collecteurs de courant, électrodes positive et négative, électrolyte, encapsulation) sont obtenues par dépôt PVD (pour « Physical Vapor Deposition ») ou CVD (pour « Chemical Vapor Deposition »). L'épaisseur totale de l'empilement est de l'ordre de 15 µm. Différents matériaux peuvent être utilisés :
- Les collecteurs de courant sont métalliques et peuvent être par exemple à base de Pt, Cr, Au, Ti.
- L'électrode positive peut être constituée de LiCoO₂, LiNiO₂, LiMn₂O₄, CuS, CuS₂, WO_{y}S_{z}, TiO_{y}S_{z}, V₂O₅, V₃O₈ ainsi que des formes lithiées de ces oxydes de vanadium et de sulfures métalliques. Selon les matériaux choisis, un recuit thermique peut être nécessaire pour augmenter la cristallisation des films et leur propriété d'insertion. Néanmoins, certains matériaux amorphes, notamment des oxysulfures de titane, ne nécessitent pas un tel traitement tout en permettant une insertion élevée d'ions lithium.
- L'électrolyte doit être bon conducteur ionique et isolant électronique. Il s'agit en général d'un matériau vitreux à base d'oxyde de bore, d'oxydes de lithium ou de sels de lithium.
- L'électrode négative peut être du lithium métallique déposé par évaporation thermique, un alliage métallique à base de lithium ou bien un composé d'insertion (SiTON, SnNₓ, InNₓ, SnO₂, ...).
- L'encapsulation a pour objet de protéger l'empilement actif de l'environnement extérieur et spécifiquement de l'humidité. Il peut être constitué de céramique, de polymère (hexaméthyldisiloxane, parylène) ou de métal ainsi que par une superposition de couches de ces différents matériaux.

Selon les matériaux utilisés, la tension de fonctionnement de ce type d'objet est comprise entre 2 et 4 V. Les capacités surfaciques sont de l'ordre de 100 µAh/cm². Les techniques utilisées permettent la réalisation d'objets de toutes surfaces et toutes formes.

A surface constante, la capacité de ces systèmes peut être augmentée principalement de deux manières:
- augmentation de l'épaisseur des électrodes,
- superposition de microbatteries connectées en parallèle.

Ces techniques sont néanmoins délicates de mise en oeuvre. Il est en effet difficile d'obtenir des couches d'épaisseur supérieure à 10 µm par PVD en conservant les propriétés initiales. Par ailleurs, les changements volumiques occasionnés dans les différentes couches par la diffusion du lithium entraînent de forts problèmes de contraintes dans les systèmes comprenant des microbatteries empilées.

Les minibatteries sont élaborées la plupart du temps à partir de techniques d'enduction. La réalisation de ces objets est en fait une réduction d'échelle des systèmes existants, obtenue par un développement du procédé de fabrication. L'épaisseur totale est de l'ordre de quelques centaines de µm (de 300 à 650 µm). Ces minibatteries sont réalisées par les fabricants actuels de batteries et commencent à être disponibles sur le marché. Leur commercialisation sera effectuée pour des applications dédiées (par exemple, développement pour alimentation d'écrans pour carte à puce).

Les capacités surfaciques de ces systèmes sont supérieures à celles des microbatteries (quelques mAh/cm² contre 100 µAh/cm²). En revanche, leur épaisseur est telle qu'elles sont incompatibles avec un positionnement sur un circuit intégré de cartes à puces (épaisseur maximale de l'ensemble 0,76 mm) et qu'elles sont difficilement intégrables dans des petits volumes (inférieurs à 1 mm³). Les couches sont actuellement fabriquées sur des supports métalliques qui sont ensuite assemblés par pressage. Il n'est pas possible de réaliser des petites surfaces (inférieures à 1 mm²). De plus, ces dispositifs ne sont pas encapsulés.

Dans la demande de brevet US 2005/0110457, il est proposé une solution mixte utilisant à la fois des couches d'électrodes déposés par des techniques couches minces (CVD, PVD, électrodéposition) et un électrolyte liquide. Néanmoins, le procédé de fabrication repose sur un empilement de couches sur un même substrat. Une cavité est créée entre les deux couches d'électrode par retrait d'une partie d'une électrode et d'un espaceur en polyimide. Une telle configuration impose de fortes contraintes mécaniques à la couche d'électrode supérieure qui est la seule à supporter l'encapsulant. Par ailleurs, ce dernier ne peut en aucun cas être un élément actif (c'est-à-dire contenir un circuit intégré ou un composant de récupération d'énergie par exemple).

Les travaux portant sur l'hybridation de microsystèmes de récupération d'une part et de stockage de l'énergie d'autre part sont beaucoup moins importants que ceux portant sur les systèmes individuels. La relative faiblesse de la production actuelle réside dans les problèmes d'intégration.

Les efforts d'intégration les plus poussés pour intégrer micro-récupération et micro-stockage de l'énergie sont conduits par Bipolar Technologies Corp. Il s'agit d'une société américaine qui, en collaboration avec Brigham Young University, développe un microsystème de fourniture d'énergie reposant sur des microbatteries Ni-Zn (avec électrolyte liquide) connectées à des cellules solaires. Ce microsystème est conçu selon une architecture planaire où tous les éléments sont disposés côte à côte, ce qui est très consommateur de surface et de volume, réduisant de ce fait l'énergie volumique (et massique) disponible.

### EXPOSÉ DE L'INVENTION

Le but de l'invention est l'obtention d'un composant intégré pouvant associer récupération, stockage et éventuellement gestion de l'énergie, tout ceci dans un volume réduit (pouvant être inférieur à 1 mm en épaisseur et aller de quelques µm² à quelques cm² en surface) et avec le maximum d'énergie embarquée. Ceci est obtenu en utilisant le volume des substrats servant à réaliser éventuellement la récupération d'énergie et/ou la fabrication de l'intelligence embarquée (circuit intégré) pour y fabriquer le stockage de l'énergie.

Un premier objet de l'invention concerne un micro-composant comprenant une source de stockage électrochimique, caractérisé en ce qu'il comprend un premier substrat présentant une face de contact et un deuxième substrat présentant une face de contact, au moins une cavité étant formée dans au moins l'un des substrats à partir de sa face de contact, les deux substrats étant solidarisés selon lesdites faces de contact par l'intermédiaire de moyens d'étanchéité, ladite cavité, rendue ainsi étanche, contenant la source de stockage électrochimique, le micro-composant fournissant des liaisons électriques entre la source de stockage électrochimique et le milieu extérieur.

Avantageusement, le micro-composant comprend en outre un dispositif de récupération d'énergie et des moyens de connexion électrique du dispositif de récupération d'énergie avec la source de stockage électrochimique. Il peut aussi comprendre en outre un circuit intégré permettant de gérer les moyens de connexion électrique entre la source de stockage électrochimique et le milieu extérieur.

Les liaisons électriques peuvent comprendre des connexions électriques traversant au moins l'un des substrats. Elles peuvent comprendre aussi des connexions filaires extérieures aux substrats.

Les moyens d'étanchéité peuvent comprendre un film anisotrope conducteur disposé entre les deux substrats et permettant une liaison électrique entre les deux substrats.

La source de stockage électrochimique peut comprendre une première électrode solidaire du premier substrat et une deuxième électrode solidaire du deuxième substrat. Des moyens de protection chimique peuvent être disposés entre une électrode et le substrat auquel elle est solidaire.

Au moins l'un des substrats peut être en matériau semiconducteur, par exemple en silicium.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1D illustrent un procédé de traitement d'un premier substrat pour la réalisation d'un micro-composant selon la présente invention,
- les figures 2A à 2D illustrent un procédé de traitement d'un deuxième substrat pour la réalisation d'un micro-composant selon la présente invention,
- la figure 3 est une vue en coupe d'un micro-composant selon la présente invention,
- la figure 4 est une vue en coupe d'un autre micro-composant selon la présente invention,
- la figure 5 est une vue en coupe d'encore un autre micro-composant selon la présente invention.

### EXPOSÉ DÉTAILLÉ DE MODES DE RÉALISATION PARTICULIERS

Selon l'invention, deux substrats sont assemblés en refermant au moins une cavité, ce qui permet l'utilisation du volume disponible de la cavité pour y réaliser une source de stockage électrochimique. Ainsi, chacun des substrats peut comporter une partie de la technologie nécessaire à la réalisation d'un système de stockage d'énergie. A partir de cette architecture, plusieurs cas peuvent être déclinés. Dans tous les cas, au moins une cavité est formée en face arrière (ou face de contact) d'au moins l'un des substrats. Une cavité réalisée dans les deux substrats permet de maximiser le volume utile pour la source d'énergie. Dans le cas d'un substrat en silicium, la cavité est typiquement obtenue par gravure KOH localisée. La paroi de la cavité doit être inerte vis-à-vis de l'électrolyte utilisé. Pour cela, il peut être nécessaire de déposer une couche d'isolation chimique et électronique sur la paroi de la cavité. Cette couche peut être par exemple un polymère. Sur cette couche, on dépose ensuite un conducteur électronique type métal (Ti, Cr, Au, Pt, ...) compatible avec les matériaux d'électrodes utilisés. Dans le cas où l'assemblage des deux substrats conduit à une isolation électronique entre eux, la couche d'inertage de la cavité peut être directement réalisée avec un métal et servir également de collecteur de courant.

Selon un premier exemple de réalisation, sur chaque substrat est déposée une couche d'électrode de batterie ou de supercapacité (positive sur l'un et négative sur l'autre). Dans ce cas, l'électrolyte présent in fine dans la cavité est liquide. Cela permet d'utiliser des couches d'électrodes épaisses (de 10 à quelques centaines de µm) car l'électrolyte peut imbiber ces couches. Il est alors possible d'obtenir des capacités très élevées (jusqu'à plusieurs 100 mAh/cm²) Selon les systèmes présents sur les substrats (circuit intégré, système de récupération d'énergie), les couches d'électrodes peuvent être choisies de telle sorte qu'elle n'aient pas à subir de recuit thermique à des températures supérieures à celle entraînant des détériorations des systèmes déjà présents. Ainsi, une couche nécessitant un recuit à 700°C ne sera pas réalisée sur la face arrière d'un circuit. Potentiellement, une telle couche peut être réalisée en face arrière du substrat avant réalisation d'autres traitements en face avant. Dans certains cas, une protection (type résine) peut être déposée afin de protéger cette couche durant le traitement de la face avant.

Les couches d'électrodes des batteries ou supercapacités peuvent être déposées par toute technique permettant d'obtenir les épaisseurs désirées. Ainsi, peuvent être utilisées des techniques utilisant des encres (contenant typiquement l'élément actif pouvant insérer le lithium par exemple, un liant polymère et un conducteur électronique) telles le jet d'encre, la sérigraphie, la flexographie, l'offset... Les techniques de dépôt sous vide (CVD, PECVD, PVD...) sont également utilisables. Sont à privilégier les techniques permettant une localisation du dépôt et une vitesse de dépôt rapide.

Selon un deuxième exemple de réalisation, sur chaque substrat sont déposées toutes les couches nécessaires à la réalisation d'une batterie ou supercapacité (électrodes et électrolyte). Cette configuration présente l'inconvénient de déposer plus de couches que dans le premier exemple de réalisation, mais elle a l'avantage de permettre de disposer de deux systèmes différents sur chacune des faces. De ce fait, il est possible par exemple d'avoir une connexion en série de ces systèmes et donc de doubler la tension de sortie. Dans le cas d'une batterie lithium, on peut ainsi obtenir un système délivrant des tensions supérieures à 8V. Dans une autre configuration, il est possible de choisir des systèmes présentant des caractéristiques différentes (batterie et supercapacité, batteries avec couples électrochimiques différents, batteries avec épaisseurs d'électrodes différentes et donc comportement en puissance différent). Une telle solution permet par exemple d'adapter une des sources à la récupération d'énergie (faible courant) et l'autre à l'alimentation d'un capteur (impulsions de courant élevées).

Cette configuration impose des connexions électriques supplémentaires : collecteur de courant sur les électrodes externes.

L'électrolyte utilisé est liquide et commun aux deux systèmes. Dans ce cas, les couches d'électrolyte déposées préalablement sont des membranes poreuses type polymère servant d'isolant électronique et mécanique entre les électrodes et pouvant se « gorger en électrolyte liquide ».

L'assemblage des deux substrats peut être obtenu de différentes manières. Deux solutions sont préférables. Selon une première solution, on réalise un pré-assemblage étanche des deux substrats et le micro-composant est immergé dans l'électrolyte après dépôt d'une colle sur le pourtour. Le collage peut être amélioré en chauffant et en pressant. Si l'étanchéité n'est pas suffisante, on peut créer une étanchéité parfaite, en dehors de l'électrolyte, par la méthode de l'encapsulant « glop top ». Selon une deuxième solution, la cavité est remplie après assemblage des deux substrats réalisé par exemple par collage anodique (ou « anodic bonding » en anglais). Le remplissage de la cavité peut alors être réalisé latéralement par présence de micro-canaux dans l'un ou l'autre des substrats ou verticalement par un trou réalisé sur l'un des substrats. Avantageusement, les phénomènes de capillarité sont utilisés pour l'introduction du liquide. L'ouverture nécessaire au remplissage est ensuite obturée par queusotage ou avec une résine.

Selon le mode de réalisation utilisé pour obtenir le micro-composant, différentes solutions de connectiques sont possibles. La solution la plus intégrée consiste à préparer des connexions traversant le substrat (réalisées avant les dépôts des couches d'électrodes). Une telle architecture permet d'être plus performant en terme d'encombrement : le volume des substrats contient non seulement les sources d'énergie mais également les connexions électriques. Idéalement le collage entre les deux substrats peut être obtenu au moyen d'un polymère type ACF (film conducteur anisotrope) permettant une conduction électrique. La connexion électrique peut donc être réalisée uniquement en face arrière ou par la partie d'assemblage de la cavité. Indépendamment de cette solution, il est également possible de réaliser des connections filaires après report des collecteurs de courant des systèmes énergétiques à l'extérieur de la cavité.

Dans la description qui suit, le micro-composant selon l'invention ne comporte qu'une seule cavité. Il est néanmoins possible de créer une multitude de petites cavités côté-à-côte permettant ainsi d'avoir un réseau de micro-sources de stockage de l'énergie et de les connecter au choix en série ou en parallèle. Une telle solution est parfaitement versatile et permet de s'adapter à différentes applications ou différents modes de fonctionnement pour une même application. De plus, répartir la source de stockage électro-chimique sur les deux substrats permet de répartir sur chaque substrat, en fonction de son éventuelle fragilité due par exemple à la présence de circuits actifs, les étapes de dépôt appropriées.

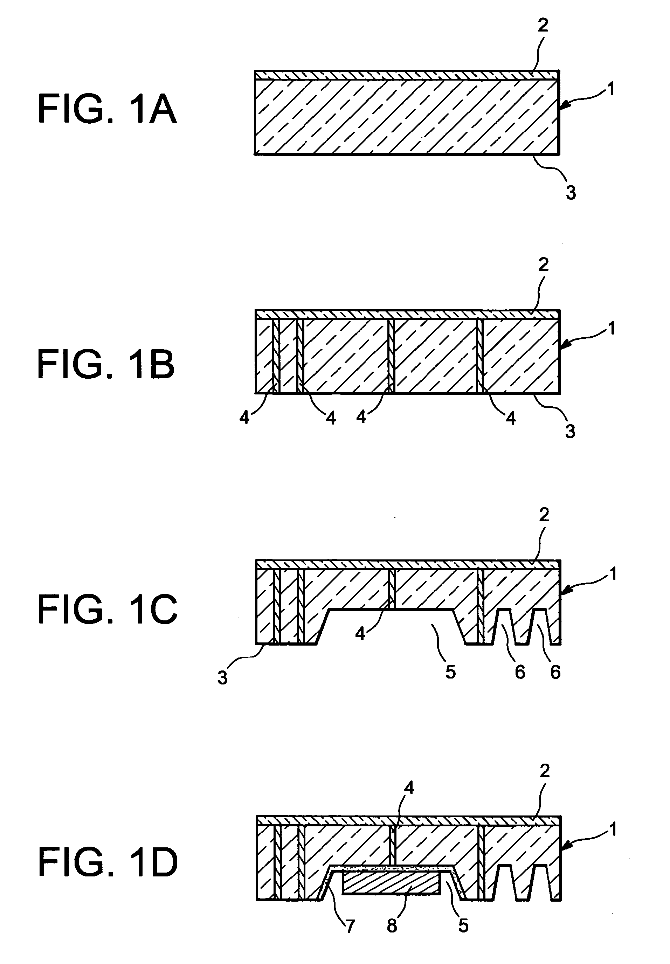

Les figures 1A à 1D illustrent un procédé de traitement d'un premier substrat pour la réalisation d'un micro-composant selon la présente invention. Ce sont des vues en coupe transversale.

La figure 1A montre un premier substrat 1 en silicium sur une face principale duquel un circuit intégré 2 a été réalisé. La face 3, opposée au circuit intégré 2, constitué la face de contact du premier substrat 1. Ensuite, des connexions électriques traversantes 4 sont réalisées par gravure puis par remplissage par un matériau conducteur. Elles permettent de connecter électriquement le circuit intégré 2 à la face de contact 3 (voir la figure 1B). Le substrat 1 est ensuite gravé à partir de la face de contact 3 (par gravure KOH localisée) pour fournir une cavité 4 et des canaux 6 servant à l'introduction de l'électrolyte et débouchant latéralement (voir la figue 1C). Une couche d'isolation (chimique et électronique) 7, par exemple un nitrure de silicium ou une silice, est ensuite déposée sur la paroi de la cavité 5 (voir la figure 1D) et une électrode 8 est réalisée au fond de la cavité en prenant soin de réaliser la liaison électrique correspondante entre l'électrode 8 et le circuit intégré 2.

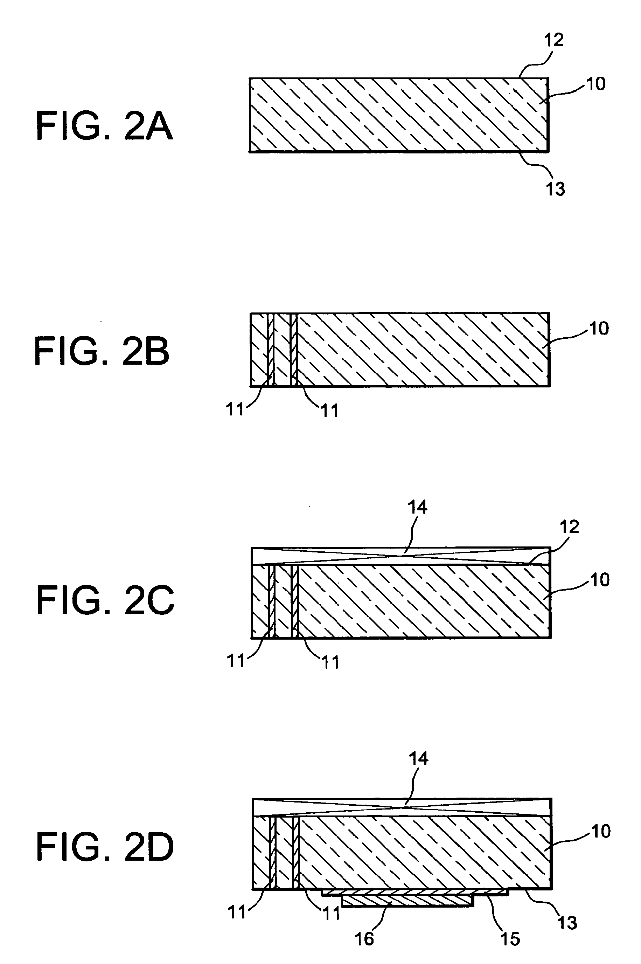

Les figures 2A à 2D illustrent un procédé de traitement d'un deuxième substrat pour la réalisation d'un micro-composant selon la présente invention. Ce sont des vues en coupe transversale.

La figure 2A montre un deuxième substrat 10 en silicium présentant une première face 12 et une deuxième face 13 dite face de contact. Des connexions électriques traversantes 11 sont réalisées dans le substrat 10, notamment en vue d'établir des liaisons électriques avec certaines des connexions électriques traversantes 4 du substrat 1 (voir la figure 2B). La figure 2C montre un dispositif de récupération d'énergie 14 fixé (par exemple par collage) sur la face 12 du substrat 10. Le dispositif 14 est électriquement relié aux connexions 11. Sur la face de contact 13, on dépose une couche d'isolation chimique et électriquement conductrice 15 par exemple en métal (voir la figure 2D). Sur la couche d'isolation 15, on dépose une électrode 16.

L'une des deux électrodes 8 ou 16 est une électrode positive et l'autre est une électrode négative. L'électrode négative peut être composée de silicium obtenu par PECVD et former une couche de 1 µm d'épaisseur. L'électrode positive peut être obtenue par sérigraphie à partir de LiCoO₂ et former une couche de 200 µm d'épaisseur.

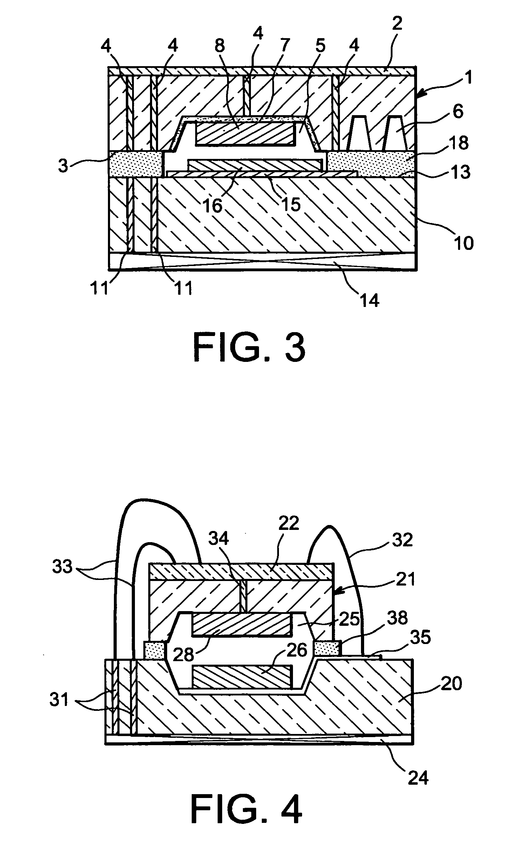

La figure 3 est une vue en coupe d'un micro-composant selon la présente invention, obtenu en solidarisant les substrats 1 et 10 selon leurs faces de contact 3 et 13. La solidarisation des substrats 1 et 10 est obtenue par collage au moyen d'un film anisotrope conducteur ou ACP, c'est-à-dire un film permettant une conduction électrique verticale par rapport au plan du film et une isolation électrique dans le plan du film. Ainsi, le circuit intégré 2 peut être électriquement relié au dispositif de récupération d'énergie 14 par l'intermédiaire de connexions électriques 4 et 11. Le circuit intégré 2 est aussi électriquement relié d'une part à l'électrode 8 grâce à une connexion traversante 4 et d'autre part à l'électrode 16 grâce à une autre connexion traversante 4, la couche métallique 15 et le film anisotrope conducteur 18.

L'électrolyte est ensuite introduit dans la cavité 5 par capillarité grâce aux canaux 6 dont l'accès est ensuite obturé.

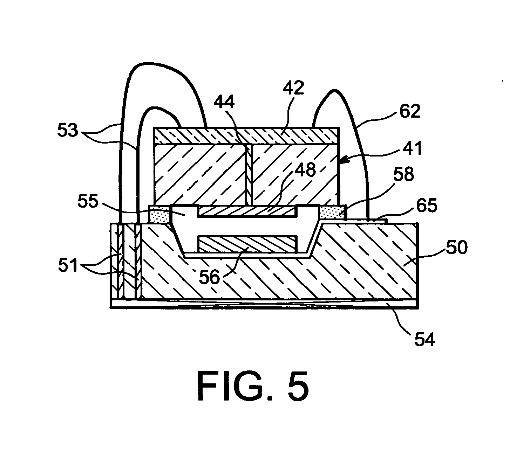

D'autres techniques de connexion électrique peuvent être utilisées comme cela est montré sur les figures 4 et 5.

Le micro-composant montré en coupe transversale à la figure 4 comprend un premier substrat 21 dont une première face principale supporte un circuit intégré 22 et dont la deuxième face principale constitue la face de contact de ce premier substrat. Le micro-composant comprend aussi un deuxième substrat 20 dont une première face principale supporte un dispositif de récupération d'énergie 24 et dont la deuxième face principale constitue la face de contact de ce deuxième substrat. La cavité interne 25 est constituée par une première cavité réalisée dans le substrat 21 et une deuxième cavité réalisée dans le substrat 20. Côté cavité 25, le premier substrat 21 supporte une électrode 28 et le deuxième substrat 20 supporte une électrode 26. Une connexion traversante 34, réalisée dans le premier substrat 21, relie électriquement le circuit intégré 22 à l'électrode 28. Une couche conductrice 35, disposée entre le deuxième substrat 20 et l'électrode 26, se prolonge sur la partie libre de la face de contact du deuxième substrat 20. Une connexion filaire extérieure 32 est établie pour relier électriquement le circuit intégré 22 à l'électrode 26 via la couche conductrice 35. Le deuxième substrat 20 comprend des connexions traversantes 31 permettant de relier électriquement le dispositif de récupération d'énergie 24 au circuit intégré 22 par l'intermédiaire de connexions filaires extérieures 33. La cavité 25 est remplie d'électrolyte. Le joint 38 assure l'étanchéité de la cavité 25.

Le micro-composant montré en coupe transversale à la figure 5 comprend un premier substrat 41 dont une première face principale supporte un circuit intégré 42 et dont la deuxième face principale constitue la face de contact de ce premier substrat. Le micro-composant comprend aussi un deuxième substrat 50 dont une première face principale supporte un dispositif de récupération d'énergie 54 et dont la deuxième face principale constitue la face de contact de ce deuxième substrat. La cavité interne 55 a été réalisée uniquement dans le deuxième substrat 50. Côté cavité 55, le premier substrat 41 supporte une électrode 48 et le deuxième substrat 50 supporte une électrode 56. Une connexion traversante 44, réalisée dans le premier substrat 41, relie électriquement le circuit intégré 42 à l'électrode 48. Une couche conductrice 65, disposée entre le deuxième substrat 50 et l'électrode 56, se prolonge sur la partie libre de la face de contact du deuxième substrat 50. Une connexion filaire extérieure 62 est établie pour relier électriquement le circuit intégré 42 à l'électrode 56 via la couche conductrice 65. Le deuxième substrat 50 comprend des connexions traversantes 51 permettant de relier électriquement le dispositif de récupération d'énergie 54 au circuit intégré 42 par l'intermédiaire de connexions filaires extérieures 53. La cavité 55 est remplie d'électrolyte. Le joint 58 assure l'étanchéité de la cavité 55.

Cette technique est particulièrement adaptée à des sources à électrolyte liquide (comme les électrolytes de type liquide ionique) mais peut tout à fait être utilisée pour des électrolytes solides.

## Revendications

1. Micro-composant comprenant une source de stockage électrochimique, **caractérisé en ce qu'**il comprend un premier substrat (1, 21, 41) présentant une face de contact (3) et un deuxième substrat (10, 20, 50) présentant une face de contact (13), au moins une cavité (5, 25, 55) étant formée dans au moins l'un des substrats à partir de sa face de contact, les deux substrats (1, 10) étant solidarisés selon lesdites faces de contact (3, 13) par l'intermédiaire de moyens d'étanchéité, ladite cavité, rendue ainsi étanche, contenant la source de stockage électrochimique, le micro-composant fournissant des liaisons électriques entre la source de stockage électrochimique et le milieu extérieur.

2. Micro-composant selon la revendication 1, **caractérisé en ce qu'**il comprend en outre un dispositif de récupération d'énergie (14, 24, 54) et des moyens de connexion électrique du dispositif de récupération d'énergie avec la source de stockage électrochimique.

3. Micro-composant selon la revendication 2, **caractérisé en ce qu'**il comprend en outre un circuit intégré (2, 22, 42) permettant de gérer les moyens de connexion électrique entre la source de stockage électrochimique et le milieu extérieur.

4. Micro-composant selon l'une quelconque des revendications 1 à 3, **caractérisé en ce que** les liaisons électriques comprennent des connexions électriques (4, 11, 31, 34, 44, 51) traversant au moins l'un des substrats.

5. Micro-composant selon l'une quelconque des revendications 1 à 4, **caractérisé en ce que** les liaisons électriques comprennent des connexions filaires (32, 33, 53, 62) extérieures aux substrats.

6. Micro-composant selon l'une quelconque des revendications 1 à 5, **caractérisé en ce que** les moyens d'étanchéité comprennent un film anisotrope conducteur (18) disposé entre les deux substrats (1, 10) et permettant une liaison électrique entre les deux substrats.

7. Micro-composant selon l'une quelconque des revendications 1 à 6, **caractérisé en ce que** la source de stockage électrochimique comprend une première électrode (8, 28, 48) solidaire du premier substrat (1, 21, 41) et une deuxième électrode (16, 26, 56) solidaire du deuxième substrat (10, 20, 50).

8. Micro-composant selon la revendication 7, **caractérisé en ce que** des moyens de protection chimique (7, 15) sont disposés entre une électrode et le substrat auquel elle est solidaire.

9. Micro-composant selon l'une quelconque des revendications 1 à 8, **caractérisé en ce qu'**au moins l'un des substrats est en matériau semiconducteur.

10. Micro-composant selon la revendication 9, **caractérisé en ce que** le matériau semiconducteur est du silicium.

## Claims

1. Microcomponent including an electrochemical storage source, **characterised in that** it includes a first substrate (1, 21, 41) having a contact face (3) and a second substrate (10, 20, 50) having a contact face (13), at least one cavity (5, 25, 55) being formed in at least one of the substrates from the contact face, the two substrates (1, 10) being secured by said contact faces (3, 13) by sealing means, wherein said cavity, thus sealed, contains the electrochemical storage source, and the microcomponent provides the electrical connections between the electrochemical storage source and the external environment.

2. Microcomponent according to claim 1, **characterised in that** it also includes an energy recovery device (14, 24, 54) and means for electrically connecting the energy recovery device with the electrochemical storage source.

3. Microcomponent according to claim 2, **characterised in that** it also includes an integrated circuit (2, 22, 42) making it possible to control the means for electrical connection between the electrochemical storage source and the external environment.

4. Microcomponent according to any one of claims 1 to 3, **characterised in that** the electrical connections include electrical connections (4, 11, 31, 34, 44, 51) passing through at least one of the substrates.

5. Microcomponent according to any one of claims 1 to 4, **characterised in that** the electrical connections include wire connections (32, 33, 53, 62) outside of the substrates.

6. Microcomponent according to any one of claims 1 to 5, **characterised in that** the sealing means include a conductive anisotropic film (18) placed between the two substrates (1, 10) allowing for an electrical connection between the two substrates.

7. Microcomponent according to any one of claims 1 to 6, **characterised in that** the electrochemical storage source includes a first electrode (8, 28, 48) secured to the first substrate (1, 21, 41) and a second electrode (16, 26, 56) secured to the second substrate (10, 20, 50).

8. Microcomponent according to claim 7, **characterised in that** the chemical protection means (7, 15) are placed between an electrode and the substrate to which it is secured.

9. Microcomponent according to any one of claims 1 to 8, **characterised in that** at least one of the substrates is made of a semiconductor material.

10. Microcomponent according to claim 9, **characterised in that** the semiconductor material is silicon.

## Patentansprüche

1. Mikrobauteil, welches eine elektrochemische Speicherquelle umfasst, **dadurch gekennzeichnet, dass** das Bauteil ein erstes Substrat (1, 21, 41) mit einer Kontaktoberfläche (3) und ein zweites Substrat (10, 20, 50) mit einer Kontaktoberfläche (13) umfasst, wenigstens einen in wenigstens einem der Substrate von dessen Kontaktoberfläche ausgehend ausgebildeten Hohlraum bzw. Ausnehmung (5, 25, 55), wobei die beiden Substrate mit den genannten Kontaktoberflächen (3, 13) mittels zwischengelagerter Dichtungsmittel miteinander verbunden sind, und wobei der so abgedichtete Hohlraum die elektrochemische Speicherquelle enthält und das Mikrobauteil elektrische Verbindungen zwischen der elektrochemischen Speicherquelle und der Außenumgebung zur Verfügung stellt.

2. Mikrobauteil nach Anspruch 1, **dadurch gekennzeichnet, dass** das Bauteil des Weiteren eine Vorrichtung zur Energiegewinnung (14, 24, 54) sowie Mittel zur elektrischen Verbindung der Energiegewinnungsvorrichtung mit der elektrochemischen Speicherquelle umfasst.

3. Mikrobauteil nach Anspruch 2, **dadurch gekennzeichnet, dass** das Bauteil des Weiteren eine integrierte Schaltung (2, 22, 42) umfasst, welche eine Steuerung der elektrischen Verbindungsmittel zwischen der elektrochemischen Speicherquelle und der Außenumgebung gestattet.

4. Mikrobauteil nach einem beliebigen der Ansprüche 1 bis 3, **dadurch gekennzeichnet, dass** die elektrischen Verbindungen elektrische Durchführungsverbindungen (4, 11, 31, 34, 44, 51) umfassen, welche wenigstens eines der Substrate umfassen.

5. Mikrobauteil nach einem beliebigen der Ansprüche 1 bis 4, **dadurch gekennzeichnet, dass** die elektrischen Verbindungen Drahtverbindungen außerhalb der Substrate umfassen.

6. Mikrobauteil nach einem beliebigen der Anspräche 1 bis 5, **dadurch gekennzeichnet, dass** die Dichtungsmittel einen anisotropen Leiterfilm (18) umfassen, der zwischen den beiden Substraten angeordnet ist und eine elektrische Verbindung zwischen den beiden Substraten gestattet.

7. Mikrobautei! nach einem beliebigen der Ansprüche 1 bis 6, **dadurch gekennzeichnet, dass** die elektrochemische Speicherquelle eine mit dem ersten Substrat (1, 21, 41) fest verbundene erste Elektrode (8, 28, 48) und eine mit dem zweiten Substrat (10, 20, 50) fest verbundene zweite Elektrode (16, 26, 56) umfasst.

8. Mikrobauteil nach Anspruch 7, **dadurch gekennzeichnet, dass** Mittel (7, 15) zum chemischen Schutz zwischen einer Elektrode und dem Substrat, mit welchem diese fest verbunden ist, angeordnet sind.

9. Mikrobauteil nach einem beliebigen der Ansprüche 1 bis 8, **dadurch gekennzeichnet, dass** wenigstens eines der Substrate aus einem Halbleitermaterial besteht.

10. Mikrobauteil nach Anspruch 9, **dadurch gekennzeichnet, dass** das Halbleitermaterial Silizium ist.
